(19) Europäisches Patentamt
European Patent Office
Office européen des brevets

(11) Veröffentlichungsnummer: **0 213 542**
**B1**

(12) # EUROPÄISCHE PATENTSCHRIFT

(45) Veröffentlichungstag der Patentschrift: **27.06.90**

(51) Int. Cl.[5]: **C 23 C 18/18**, C 23 C 18/28, C 23 F 1/32, H 05 K 3/00

(21) Anmeldenummer: **86111478.3**

(22) Anmeldetag: **19.08.86**

(54) **Konditionierungsmittel für die Behandlung von Basismaterialien.**

(30) Priorität: **23.08.85 DE 3530617**

(43) Veröffentlichungstag der Anmeldung:
**11.03.87 Patentblatt 87/11**

(45) Bekanntmachung des Hinweises auf die Patenterteilung:
**27.06.90 Patentblatt 90/26**

(84) Benannte Vertragsstaaten:
**BE CH DE FR GB IT LI LU NL SE**

(56) Entgegenhaltungen:
**EP-A-0 100 452**
**CH-A- 573 956**
**DE-A-3 328 765**
**US-A-3 684 572**

(73) Patentinhaber: **SCHERING AKTIENGESELLSCHAFT Berlin und Bergkamen**
**Müllerstrasse 170/178 Postfach 65 03 11**
**D-1000 Berlin 65 (DE)**

(72) Erfinder: **Grapentin, Hans-Joachim**
**Wundtstrasse 17**
**D-1000 Berlin 19 (DE)**
Erfinder: **Seidenspinner, Hubert-Matthias, Dr.**
**Mescheder Weg 36**
**D-1000 Berlin 27 (DE)**
Erfinder: **Tessmann, Detlef**
**Fuggerstrasse 21**
**D-1000 Berlin 30 (DE)**

**EP 0 213 542 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Courier Press, Leamington Spa, England.

**Beschreibung**

Die Erfindung betrifft ein Konditionierungsmittel zur Behandlung von Basismaterialien für die nachfolgende vollständige und gleichmäßige chemische Metallisierung gemäß Oberbegriff des Anspruchs 1.

Unter Konditionierung wird die Vorbereitung oder Veränderung einer Substratoberfläche einschließlich der Füllstoffe (zum Beispiel Glasfaser) verstanden, mit dem Ziel, die Aktivierung (Bekeimung) vollständig und gleichmäßig zu gewährleisten und damit die chemische Metallisierung positiv zu beeinflussen.

Es ist bekannt, daß gerade die Vorbehandlung, abgestimmt auf einen geeigneten Aktivator, befiedigende Ergebnisse in der Metallisierung liefern kann, wobei die Haftung zwischen dem Substrat und Metall weitgehend von der jeweiligen Ätzung, angepaßt auf das entsprechende Material, abhängig ist.

Aus der zitierten DE—A—33 28 765 ist weiterhin bereits die Vorbehandlung von Polyimid mit Alkalihydroxidlösung, insbesondere mit einer organischen Stickstoffverbindung in Gegenwart eines zweiwertigen Metalls bekannt geworden. Dabei weden als Stickstoffverbindungen primäre, sekundäre und tertiäre Amine vorgeschlagen, nicht jedoch Quartärsalze oder polyquarternäre Salze vcon N-alkenylsubstituierten cyclischen Stickstoffverbindungen, wie bei der vorliegenden Erfindung.

Lediglich ein kationaktives Netzmittel — quarternisierter Fettaminpolyglykolether — wird in dieser Druckschrift als Zusatzmittel für das Palladiumreduktionsbad genannt, das jedoch kein Konditionierungsmittel darstellt.

Aufgabe der vorliegenden Erfindung ist die Zurverfügungstellung eines Konditionierungsmittels zur Vorbehandlung von Basismaterialien mit überlegenen Eigenschaften.

Diese Aufgabe wird erfindungsgemäß durch ein Mittel der eingangs bezeichneten Art gelöst, das dadurch gekennzeichnet, ist, daß dieses Quartärsalze von N-alkenylsubstituierten cyclischen Stickstoffverbindungen und/oder polyquarternäre Salze dieser Verbindungen enthält.

Vorteilhafte Weiterbildungen der Erfindung sind in den Unteransprüchen beschrieben.

Die erfindungsgemäße Lösung bewirkt im Vergleich zum Stand der Technik eine gesteigerte Aktivierung der Oberflächen von Basismaterialien und ermöglicht somit deren vollständige und gleichmäßige chemische Metallisierung.

Von besonderem Vorteil ist es, daß das erfindungsgemäße Konditionierungsmittel mit allen bekannten Aktivatorsystemen gleich gute Metallisierung ermöglicht nach dem allgemeinen Arbeitsblauf:

Konditionieren
Metallätzung
Aktivierung
Chemische Metallisierung

In der Regel wird dem Konditionieren noch eine Reinigung vorgesetzt, die jedoch auch gleichzeitig mit dem Konditionieren durchgeführt werden kann.

Die Aktivierung wird meist mit palladiumhaltigen Lösungen vorgenommen, kann jedoch auch mit anderen Edelmetallsalzlösungen, wie die der Silbersalze, durchgeführt werden.

Die erfindungsgemäß zu verwendenden quarternären organischen Stickstoffverbindungen sind an sich bekannt oder können nach an sich bekannten Verfahren hergeleitet werden.

Diese Verbindungen entsprechen der allgemeinen Formel

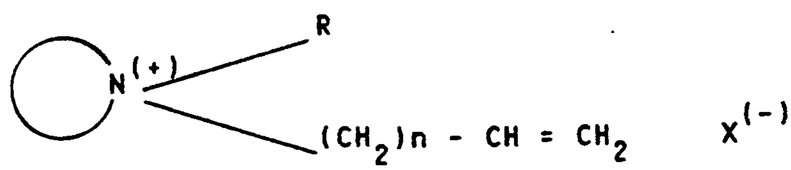

enthält, worin

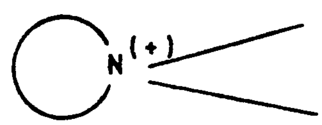

eine cyclische Stickstoffverbindung,

R Wasserstoff, $C_1$—$C_4$-Alkyl oder Hydroxi — $C_1$—$C_2$-alkyl,

n 0 oder 1

und

$X^{(-)}$ das Anion einer anorganischen oder organischen Säure bedeuten.

Als Verbindungen mit herausragender Wirkung sind insbesondere

N-Methyl-N′-vinylimidazoliummetholsulfat
N-Methyl-N′-vinylimidazoliumchlorid

N-Methyl-N'-vinylpyrrolidoniumchlorid
N-Methyl-N'-allylimidazoliumjodid
N-Methyl-N'-vinyl-ε-caprolactam-quartärsalz
N-Butyl-N'-allylbenzimidazoliummethosulfat und
N-Methyl-N'-vinylimidazolium-bromid oder methansulfonat
zu nennen.

Die Anwendung dieser Verbindungen erfolgt vorzugsweise in wässriger Lösung in Konzentrationen von 0,01 bis 10 g/Liter.

Die erfindungsgemäßen Verbindungen eignen sich zur Vorbehandlung aller bekannten Basismaterialien, wie zum Beispiel Epoxid-Hartpapier, Phenolharz, Polyimid, Polyamid, Polystyrol, Polyäthylen, Polyvinylchlorid, Polycarbonat, Acrylat, Acrylnitril-Butatien-Styrol Blockpolymerisat, Polysulfon, Polyester, Teflon, Glas oder Keramik.

Die Wirkung der erfindungsgemäß zu verwendenden Verbindungen kann überraschenderweise gesteigert werden, wenn diese in Kombination mit Dicarbonsäure, vorzugsweise Oxalsäure, Malonsäure, Bernsteinsäure, Glutarsäure, Adipinsäure oder Maleinsäure angewendet werden, vorteilhafterweise in Konzentrationen von 1 bis 10 g/Liter, vorzugsweise 5 g/Liter.

Die gleichzeitige Anwesenheit eines Reinigungsmittels auf Basis eines nichtionogenen Netzmittels, vorzugsweise Alkylphenolpolyglykoläther, ist ohne weiteres möglich, so daß der Reinigungsvorgang mit der Konditionierung kombiniert werden kann, was technisch vorteilhaft ist.

Das erfindungsgemäße Mittel wird bei Temperaturen von etwa 15 bis 30°C, vorzugsweise 20°C, angewendet, jedoch hat die Arbeitstemperatur keinen nennenswerten Einfluß auf die Belegungsergebnisse.

Das erfindungsgemäße Mittel findet Verwendung zur Herstellung von Leiterplatten in der Elektrotechnik und Elektronik.

Die Folgenden Beispiele dienen zur Erläuterung der Erfindung.

Beispiel 1

Es wurde ein chemisches Metallisierungsverfahren mit einem gebohrten, kupferkaschiertem Epoxid/Glasfaser-Material wie folgt durchgeführt:

| | | Zeit (Min.) | Temperatur (°C) |
|---|---|---|---|
| 1. Reinigen | | <u>5</u> (4 - 6) | 40 (RT - 80) |
| 2. Ätzreinigen, | zum Beispiel $H_2SO_4/H_2O_2$ - Ätze | <u>1</u> (0,5 - 3) | 30 (RT - 40) |
| 3. Aktivierung | | <u>5</u> (4 - 6) | 30 (RT - 50) |
| 4. chemische Metallisierung, zum Beispiel Kupfer | | | |

Als konventioneller Reiniger wurde ein nichtionogenes Netzmittel, zum Beispiel auf Basis von Alkylphenolpolyglykoläther, verwendet, der für Epoxid geeignet ist, aber keine Zusätze einer Verbindung mit konditionierenden Eigenschaften enthält.

Sowohl in einfacher alkalischer als auch in saurer oder neutraler oder in einer kombinierten Doppelstufenreinigung (alkalisch/sauer oder umgekehrt) konnte nach einer Kupferabscheidung von 5 µm keine 100 prozentige Belegung, vor allem der Glasfaser, beobachtet werden.

Beispiel 2

Beispiel 1 wurde wiederholt, wobei dem einstufigen stark alkalischen Reiniger (pH = größer als 13) 10 mg/Liter einer quarternären organischen Stickstoffverbindung auf Basis von N-Methyl-N'-vinylimidazoliummethosulfat zugesetzt wurde.

Auf dem Basismaterial entstand eine geschlossene Metallisierung nach etwa 5 µm Kupfer.

Beispiel 3

Beispiel 2 wurde wiederholt unter Verwendung von 100 mg/Liter N-Methyl-N'-vinylimidazoliummethosulfat.

Man erhielt eine 100 prozentigew Belegung nach etwa 3 µm Kupfer.

Beispiel 4

Beispiel 2 wurde wiederholt unter Verwendung von 250 mg/Liter N-Methyl-N'-vinylimidazoliumchlorid.

Die geschlossene Kupferschicht war bereits nach einer Schichtdicke von etwa 0,5 µm erreicht.

Beispiel 5

Beispiel 2 wurde wiederholt unter Verwendung von 1 g/Liter N-Methyl-N'-vinylimidazoliummethosulfat.

Eine 100 prozentige Belegung war bereits nach einer Schichtdicke von etwa 0,5 µm erreicht.

Beispiel 6

Beispiel 2 wurde wiederholt unter Verwendung von 10g/Liter N-Methyl-N'-vinylimidazoliummethosulfat.

Eine geschlossene Metallisierung wurde nach einer Schichtdicke von annähernd 0,5 µm erreicht.

Beispiel 7

Beispiel 4 wurde wiederholt, wobei dem Reiniger zusätzlich 5 g/Liter Bernsteinsäure zugesetzt wurden.

Es wurde eine verbesserte Konditionierung festgestellt. Die Kupferbelegung war bereits nach einer ungefähren Schichtdicke von 0,2 µm 100 prozentig.

Beispiel 8

Die Beispiele 2 bis 7 wurden wiederholt unter Verwendung eines einstufigen stark sauren Reinigers (pH = kleiner 1), dem jeweils 10 mg/Liter, 100 mg/Liter, 1 g/Liter oder 10 g/Liter einer quarternären organischen Stickstoffverbindung auf Basis von N-Methyl-N'-vinylimidazoliummethosulfat zugesetzt wurden.

Die Versuchsbefunde entsprechen den in den Beispielen 2 bis 7 aufgeführten Ergebnissen.

Beispiel 9

Beispiel 8 wurde wiederholt unter Verwendung eines einstufigen Reinigers im neutralen Medium unter Zusatz der Verbindung auf Basis von N-Methyl-N'-vinylimidazoliummethosulfat.

Auch hier wurden Metallisierungsverbesserungen festgestellt.

Beispiel 10

Versuch 7 wurde wiederholt mit einer doppelstufigen, alkalisch sauren Vorbehandlung.

Eine geschlossene 100 prozentige chemische Verkupferung wurde bereits nach einer Schichtdicke von etwa 0,1 µm erhalten.

Beispiel 11

Eine Wiederholung des Versuchs 10 mit einer doppelstufigen, sauren, alkalischen Vorbehandlung ergab analoge Ergebnisse.

Beispiel 12

Eine Wiederholung der Versuche 2 bis 11 mit plasmageätzten Mehrlagenschaltungen (Multilayer) ergab eine sichere Belegung mit stromlosem Kupfer nach einer Schichtdicke von etwa 0,2 µm.

Beispiel 13

Ähnliche Ergebnisse wie in Versuch 12 erreicht wurden, wenn Mehrlagenschaltungen mit

konzentrierter Schwefelsäure
Chromsäure oder
einer alkalischen Kupfermanganatlösung

geätzt waren.

Beispiel 14

Analoge Ergebnisse wie in den Beispielen 2 bis 11 wurden erhalten, wenn der Palladiumgehalt im ionogenen Aktivator von 200 auf 75 mg/Liter gesenkt wurde.

Beispiel 15

Analoge Ergebnisse wie in den Beispielen 2 bis 11 wurden erhalten, wenn die Palladiumkonzentration von 200 auf 100 mg/Liter in einem kolloidalen, zinn(II)-haltigen und sauren Aktivator reduziert wurde.

Beispiel 16

Bei Wiederholung der Beispiele 1 bis 11 mit silberhaltigen und kupferhaltigen Aktivatoren wurden vergleichbare Resultate erzielt.

Beispiel 17

Die Beispiele 10 und 11 wurden unter Verwendung von Epoxid-Hartpapier, Phenolharz, Polyimid, Polyamid, Acrylnitril-Butatien-Styrol Blockpolymerisat (ABS), Polysulfon, Teflon und Porzellan mit analogen Ergebnissen wiederholt.

Beispiel 18

Die Beispiele 2 bis 17 wurden unter Verwendung eines chemischen Nickelbades wiederholt, wobei das erfindungsgemäße Konditionierungsmittel die belegungsfördernde Wirkung verursachte, wenn man mit stromlosen Nickelbädern metallisiert.

**Patentansprüche**

1. Konditionierungsmittel zur Behandlung von Basismaterialien für die nachfoldgende vollständige und gleichmäßige Metallisierung, dadurch gekennzeichnet, daß dieses Quartärsalze von N-alkenylsubstituierten cyclischen Stickstoffverbindungen und/oder polyquarternäre Salze dieser Verbindungen enthält.

2. Konditionierungsmittel gemäß Anspruch 1, dadurch gekennzeichnet, daß dieses Verbindungen der allgemeinen Formel

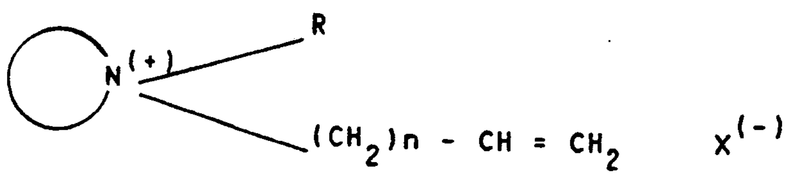

enthält, worin

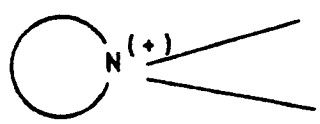

eine cyclische Stickstoffverbindung,

R Wasserstoff, $C_1$—$C_4$-Alkyl oder Hydroxi-$C_1$—$C_2$-alkyl,

n 0 oder 1

und

$X^{(-)}$ das Anion einer anorganischen oder organischen Säure bedeuten.

3. Konditionierungsmittel gemäß Anspruch 2, worin

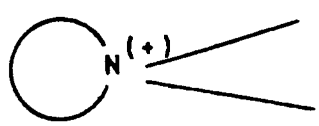

einen Pyrrolidon-, Imidazolin-, Imidazol-, ε-Caprolactam- oder Benzimidazolrest, bedeuten.

4. Konditionierungsmittel gemäß Anspruch 1, gekennzeichnet durch einen Gehalt an N-Methyl-N'-vinylimidazoliummethosulfat.

5. Konditionierungsmittel gemäß Anspruch 1, gekennzeichnet durch einen Gehalt an N-Methyl-N'-vinylimidazoliumchlorid.

6. Konditionierungsmittel gemäß Anspruch 1, gekennzeichnet durch einen Gehalt an N-Methyl-N'-vinlypyrrolidoniumchlorid.

7. Konditionierungsmittel gemäß Anspruch 1, gekennzeichnet durch einen Gehalt an N-Methyl-N'-allylimidazoliumjodid.

8. Konditionierungsmittel gemäß Anspruch 1, gekennzeichnet durch einen Gehalt an N-Methyl-N'-vinyl-ε-caprolactam-quartärsalz.

9. Konditionierungsmittel gemäß Anspruch 1, gekennzeichnet durch einen Gehalt an N-Methyl-N'-allylbenzimidazoliummethosulfat.

10. Konditionierungsmittel gemäß Anspruch 1, gekennzeichnet durch einen Gehalt an einem Copolymerisat aus N-Methyl-N'-vinylimidazoliumchlorid und -vinyl-pyrrolidon.

11. Konditionierungsmittel gemäß Ansprüchen 1 bis 10, enthaltend Quartärsalze von N-alkenylsubstituierten cyclischen Stickstoffverbindungen und/oder polyquarternäre Salze dieser Verbindungen in Konzentrationen von 0,01 bis 10 g/Liter.

12. Konditionierungsmittel gemäß Anspruch 1, dadurch gekennzeichnet, daß es als wässrige Lösung vorliegt.

13. Konditionierungsmittel gemäß Anspruch 1, dadurch gekennzeichnet, daß es zusätzlich nichtionogene Netzmittel als Reinigungsmittel enthält.

14. Konditionierungsmittel gemäß Anspruch 13 dadurch gekennzeichnet, daß es Alkylphenolpolyglykoläther als Netzmittel enthält.

15. Konditionierungsmittel gemäß Anspruch 1, dadurch gekennzeichnet, daß es zusätzlich Dicarbonsäuren enthält.

16. Konditionierungsmittel gemäß Anspruch 15, dadurch gekennzeichnet, daß es Oxalsäure, Malonsäure, Bernsteinsäure, Glutarsäure, Adipinsäure oder Maleinsäure enthält.

17. Konditionierungsmittel gemäß Ansprüchen 15 und 16, enthaltend die Dicarbonsäuren in Konzentrationen von 1 bis 10 g/Liter, vorzugsweise 5 g/Liter.

18. Verwendung eines Konditionierungsmittels gemäß Ansprüchen 1 bis 17 Behandlung von Basismaterialien auf Basis von Epoxid-Hartpapier, Phenolharz, Polyimid, Polyamid, Polystyrol, Polyäthylen, Polyvinylchlorid, Polycarbonat, Acrylat, Acrylnitril-Butadien-Styrol Blockpolymerisat, Polysulfon, Polyester, Teflon, Glas oder Keramik.

**Revendications**

1. Agent de conditionnement pour le traitement de supports isolants en vue d'une métallisation ultérieure complète et régulière, ledit agent étant caractérisé par le fait qu'il contient des sels quarternaires de composés nitriques cycliques, substitués N-alcényle, et/ou des sels polyquarternaires de ces composés.

2. Agent de conditionnement selon la revendication 1, caractérisé en ce que ce dernier contient des composés dont la formule générale est

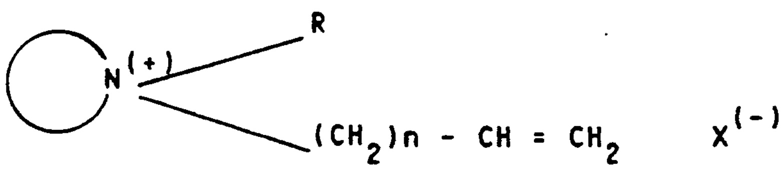

où

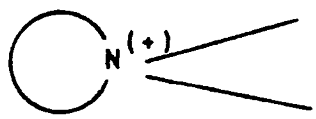

signifie un composé nitrique cylique

R signifie hydrogène, $C_1$—$C_4$-alkyle ou hydroxy-$C_1$—$C_2$-alkyle

n signifie 0 ou 1

et

$X^{(-)}$ signifie l'anion d'un acide anorganique ou organique.

3. Agent de conditionnement selon la revendication 2, dans lequel

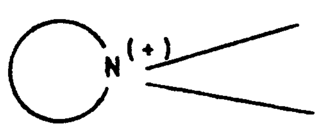

signifie un radical de pyrrolidone, imidazoline, imidazole, ε-caprolactame ou benzimidazole.

4. Agent de conditionnement selon la revendication 1, caractérisé en ce qu'il contient de methosulfate de N-methyl-N'-vinylimidazole.

5. Agent de conditionnement selon la revendication 1, caractérisé en ce qu'il contient de chlorure de N-méthyl-N'-vinylimidazole.

6. Agent de conditionnement selon la revendication 1, caractérisé en ce qu'il contient de chlorure de N-méthyl-N'-vinylpyrrolidone.

7. Agent de conditionnement selon la revendication 1, caractérisé en ce qu'il contient de d'iodure de N-méthyl-N'-allylimidazole.

8. Agent de conditionnement selon la revendication 1, caractérisé en ce qu'il contient de sel quarternaire de N-méthyl-N'-vinyl-ε-caprolactame.

9. Agent de conditionnement selon la revendication 1, caractérisé en ce qu'il contient de methosulfate de N-butyl-N'-allylbenzimidazole.

10. Agent de conditionnement selon la revendication 1, caractérisé en ce qu'il contient un copolymère composé de chlorure de N-méthyl-N'-vinylimidazole et -vinylpyrrolidone.

11. Agent de conditionnement selon les revendications 1 à 10, caractérisé en ce qu'il contient des sels quarternaires de composés nitriques cycliques, substitués N-alcényle, et/ou des sels polyquarternaires de ces composés dans des concentrations de 0,01 à 10 g/litre.

12. Agent de conditionnement selon la revendication 1, caractérisé en ce qu'il se présente en forme de solution aqueuse.

13. Agent de conditionnement selon la revendication 1, caractérisé en ce qu'il contient en plus des agents mouillants non-ioniques comme produit de rinçage.

14. Agent de conditionnement selon la revendication 13, caractérisé en ce qu'il contient d'éther alkylphénolique de polyglycole comme agent mouillant.

15. Agent de conditionnement selon la revendication 1, caractérisé en ce qu'il contient en plus des acides dicarboxyliques.

16. Agent de conditionnement selon la revendication 15, caractérisé en ce qu'il contient de l'acide oxalique, de l'acide malonique, de l'acide succinique, de l'acide glutairque, de l'acide adipique ou de l'acide maléique.

17. Agent de conditionnement selon les revendications 15 et 16, contenant les acides discarboxyliques dans des concentrations de 1 à 10 g/litre, et de préférence de 5 g/litre.

18. Utilisation d'un agent de conditionnement selon les revendications 1 à 17 pour le traitement de supports isolants sur la base de papier durci epoxy, de résine phénolique, de polyimide, de polyamide, de polystyrène, de polyéthylène, de chlorure de polyvinyle, de polycarbonate, d'acrylate, de polymère en masse d'acrylnitrile-styrène- butadiène, de polysulfone, de polyester, de teflon, de verre ou de céramique.

**Claims**

1. Conditioning agent for treating substrate materials for subsequent complete and uniform metal-plating, characterized in that it contains quarternary salts of N-alkenyl substituted cyclic nitrogen compounds and/or polyquarternary salts of these compounds.

2. Conditioning agent in accordance with Claim 1, characterized in that it contains compounds of the general formula

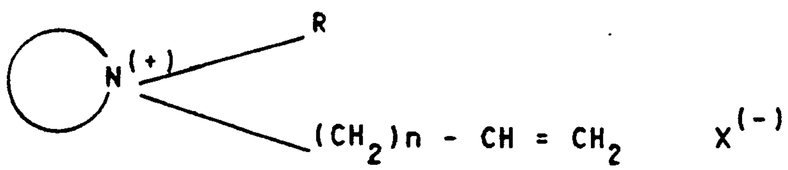

where

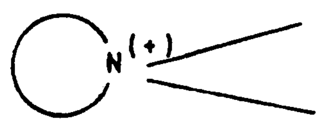

is a cyclic nitrogen compound,

R is hydrogen, $C_1$—$C_4$-alkyl or hydroxy-$C_1$—$C_2$-alkyl,

n is 0 or 1

and $X^{(-)}$ is the anion of an inorganic or organic acid.

3. Conditioning agent in accordance with Claim 2 where

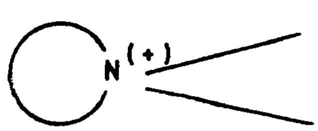

is a pyrrolidone-, imidazoline-, imidazole-, ε-caprolactam or benzimidazole radical.

4. Conditioning agent in accordance with Claim 1, characterized in that it contains N-methyl-N'-vinylimidazole methosulfate.

5. Conditioning agent in accordance with Claim 1, characterized in that it contains N-methyl-N'-vinylimidazole chloride.

6. Conditioning agent in accordance with Claim 1, characterized in that it contains N-methyl-N'-vinylpyrrolidone chloride.

7. Conditioning agent in accordance with Claim 1, characterized in that it contains N-methyl-N'-allylimidazole iodide.

8. Conditioning agent in accordance with Claim 1, characterized in that it contains a quarternary salt of N-methyl-N'-vinyl-ε-caprolactam.

9. Conditioning agent in accordance with Claim 1, characterized in that it contains N-methyl-N'-allylbenzimidazole methosulfate.

10. Conditioning agent in accordance with Claim 1, characterized in that it contains a copolymer comprised of N-methyl-N'-vinylimidazole chloride and -vinylpyrrolidone.

11. Conditioning agent in accordance with Claims 1 to 10, containing quarternary salts of N-alkenyl substituted cyclic nitrogen compounds and/or polyquarternary salts of these compounds at concentrations of 0.01 to 10 g/liter.

12. Conditioning agent in accordance with Claim 1, characterized in that it is present in the form of an aqueous solution.

13. Conditioning agent in accordance with Claim 1, characterized in that it additionally contains non-ionogenic wetting agents as rinsing agents.

14. Conditioning agent in accordance with Claim 13, characterized in that it contains alkylphenol polyglycol ether as the wetting agent.

15. Conditioning agent in accordance with Claim 1, characterized in that it contains dicarboxylic acids in addition.

16. Conditioning agent in accordance with Claim 15, characterized in that it contains oxalic acid, malonic acid, succinic acid, glutaric acid, adipic acid or maleic acid.

17. Conditioning agent in accordance with Claims 15 and 16 containing dicarboxylic acids at concentrations of 1 to 10 g/liter, preferably 5 g/liter.

18. Use of a conditioning agent in accordance with Claims 1 to 17 for treatment of substrate materials on the basis of epoxy laminated paper, phenolic resin, polyimide, polyamide, polystyrene, polyethylene, polyvinyl chloride, polycarbonate, acrylate, acrylonitrile-butadiene-styrene block-polymer, polysulfone, polyester, teflon, glass or ceramics.